(19) Europäisches Patentamt

European Patent Office

Office européen des brevets

(11) **EP 3 214 576 A1**

(12) **DEMANDE DE BREVET EUROPEEN**

(43) Date de publication:
06.09.2017 Bulletin 2017/36

(51) Int Cl.:
*G06K 9/00* (2006.01)   *G01J 5/08* (2006.01)

(21) Numéro de dépôt: **17158288.5**

(22) Date de dépôt: **28.02.2017**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**
Etats d'extension désignés:
**BA ME**
Etats de validation désignés:
**MA MD**

(30) Priorité: **01.03.2016 FR 1651705**

(71) Demandeur: **Commissariat à l'Energie Atomique et aux Energies Alternatives 75015 Paris (FR)**

(72) Inventeurs:
• BECKER, Sébastien
  38500 Voiron (FR)
• MAINGUET, Jean-François
  38100 Grenoble (FR)

(74) Mandataire: **Brevalex**
  **56, Boulevard de l'Embouchure**
  **B.P. 27519**
  **31075 Toulouse Cedex 2 (FR)**

(54) **CAPTEUR DE MOTIFS THERMIQUES À BOLOMÈTRES SOUS CAPSULE(S)**

(57)   L'invention concerne un capteur (100) de motifs thermiques d'un objet, de type capteur d'empreinte papillaire, comprenant une surface de contact (171) pour y appliquer l'objet.

Le capteur comprend :
- au moins une capsule (150) scellée sous vide, disposée entre un substrat (130) et la surface de contact, adaptée à échanger de la chaleur avec l'objet et à émettre un rayonnement électromagnétique fonction de sa température ;
- à l'intérieur de chaque capsule (150), au moins une planche bolométrique (110), pour convertir en chaleur un rayonnement électromagnétique incident ;
- au moins un filtre optique (160), pour arrêter un rayonnement électromagnétique dans l'infra-rouge, chaque capsule étant recouverte par un filtre optique ; et
- des moyens de lecture (140) des résistances électriques des planches bolométriques (110).

Un tel capteur d'empreinte offre à la fois une bonne isolation entre le substrat et les éléments sensibles, et une bonne tenue mécanique.

FIG.1

## Description

**DOMAINE TECHNIQUE**

L'invention concerne le domaine des capteurs ou détecteurs de motifs thermiques, ou capteurs de l'empreinte thermique d'un objet, pour imager les motifs thermiques d'un objet, dit objet à imager.

De tels capteurs mesurent une répartition en deux dimensions de la masse thermique d'un objet avec lequel ils sont en contact physique direct, et même de sa capacité thermique et/ou de sa conductivité thermique.

Ils forment des transducteurs d'une variation temporelle de température, en une différence de potentiels ou de courants.

Un tel capteur peut former un appareil d'analyse de type spectromètre de masse, ou débitmètre (en chauffant l'objet en un emplacement et en mesurant jusqu'où la chaleur se propage). Il peut notamment former des moyens de mesures en diverses profondeurs dans un objet, en faisant varier des puissances injectées pour chauffer l'objet, et des temps de mesure.

Il peut également former un capteur d'empreinte papillaire, pour imager une empreinte liée aux plis particuliers de la peau, en particulier une empreinte digitale, mais également une empreinte palmaire, plantaire, ou phalangeaire. Ces diverses empreintes sont désignées ensemble sous le terme d'empreintes papillaires.

Un tel capteur d'empreinte papillaire utilise une différence d'impact thermique, sur une surface de contact, entre des régions en contact physique direct avec le doigt, au niveau des crêtes de l'empreinte, et des régions hors contact physique direct avec le doigt, au niveau des vallées de l'empreinte.

**ÉTAT DE LA TECHNIQUE ANTÉRIEURE**

On connaît dans l'art antérieur différents types de capteurs de motifs thermiques, en particulier une empreinte papillaire.

On connaît par exemple des capteurs basés sur les propriétés pyroélectriques d'un matériau tel que le PVDF. Un tel matériau ne mesure cependant que des variations de température en fonction du temps. Après un intervalle de temps très court, les températures se stabilisent et l'image obtenue est insuffisamment contrastée.

On connaît également des capteurs basés sur les propriétés thermo-résistives d'un matériau, dont la résistance est fonction de la température.

Lorsqu'on pose le doigt sur le capteur, le contact avec le doigt chauffe le matériau thermo-résistif. La température du matériau thermo-résistif varie, selon qu'il est recouvert par une région du doigt correspondant à une crête de l'empreinte digitale, ou à une vallée de l'empreinte digitale. On peut ainsi former une image de l'empreinte digitale.

Le document US 6,633,656 décrit un exemple d'un tel capteur. Le matériau thermo-résistif est l'oxyde de vanadium ($VO_x$). Il est déposé sous la forme d'une couche pixellisée, directement sur un substrat, ou isolé de celui-ci par une couche d'un matériau isolant.

Malgré la présence éventuelle du matériau isolant, la chaleur est transmise rapidement de la couche de $VO_x$ vers le substrat, ce qui nuit au contraste de l'image obtenue.

On connaît également le capteur d'empreinte digitale décrit dans l'article de Ji-Song Han, « Thermal Analysis of Fingerprint Sensor Having a Microheater Array », International Symposium on Micromechatronics and Human Science, 1999 IEEE.

Dans cet article, les auteurs étudient les caractéristiques d'un capteur thermique dans lequel chaque pixel est constitué d'un barreau de silicium.

Le barreau de silicium présente une région centrale, formant la zone sensible d'un pixel du capteur, encadrée par deux régions latérales recevant des électrodes.

Le barreau de silicium est chauffé, la détection exploitant les propriétés de transmission de chaleur entre le barreau de silicium et la peau.

La zone sensible du barreau de silicium est également encadrée par deux cavités, gravées dans le substrat. Ces deux cavités se rejoignent sous la zone sensible, et améliorent une isolation thermique entre le barreau de silicium et le substrat.

Un inconvénient de cette réalisation est notamment que le taux de remplissage surfacique des éléments sensibles, ici les régions centrales des barreaux de silicium, est limité, notamment par l'encombrement latéral des cavités gravées.

Un objectif de la présente invention est de proposer un capteur de motifs thermiques tels qu'une empreinte papillaire, présentant à la fois une isolation thermique optimisée entre les éléments sensibles et un substrat, et un fort taux de remplissage des éléments sensibles.

**EXPOSÉ DE L'INVENTION**

Cet objectif est atteint avec un capteur de motifs thermiques d'un objet, en particulier une empreinte papillaire, comprenant une surface de contact pour y appliquer l'objet à imager.

Selon l'invention, le capteur comprend :

- au moins une capsule scellée sous vide, disposée entre un substrat et ladite surface de contact, adaptée à échanger de la chaleur par conduction avec l'objet à imager et à émettre un rayonnement électromagnétique en fonction de la température de la capsule ;
- à l'intérieur de chaque capsule scellée sous vide, au moins une planche bolométrique, adaptée à convertir en chaleur un rayonnement électromagnétique incident provenant de la capsule ;
- au moins un filtre optique, pour arrêter un rayonnement électromagnétique dans l'infra-rouge, chaque capsule étant recouverte par un filtre optique ; et
- des moyens de lecture des résistances électriques des planches bolométriques.

Les planches bolométriques forment les éléments sensibles du capteur selon l'invention.

En fonctionnement, l'utilisateur met un objet en contact physique direct avec la surface de contact du capteur selon l'invention.

Il se produit un transfert thermique entre la ou les capsule(s), située(s) sous la surface de contact, et l'objet.

On parle aussi d'échange de chaleur, pour désigner un transfert thermique. La direction du transfert thermique dépend des températures respectives de la peau et des capsules, la chaleur se dirigeant de l'élément le plus chaud vers l'élément le plus froid.

Les faces internes de chaque capsule émettent un rayonnement électromagnétique en direction des planches bolométriques.

La puissance de ce rayonnement électromagnétique est directement liée à la température de la capsule, elle-même liée à l'échange de chaleur avec l'objet.

Chaque planche bolométrique reçoit donc un rayonnement électromagnétique dont la puissance dépend de la température locale de l'objet, au-dessus de ladite planche.

Le rayonnement électromagnétique incident sur une planche bolométrique est absorbé par celle-ci, et modifie sa température.

La résistance électrique de la planche bolométrique est fonction de sa température. Ainsi, la nouvelle température de la planche bolométrique définit une nouvelle résistance électrique de la planche bolométrique, lue par des moyens de lecture des résistances électriques des planches bolométriques.

Les moyens de lecture des résistances électriques des planches bolométriques peuvent notamment mesurer, pour chaque planche bolométrique, une variation de résistance électrique induite par la variation de flux électromagnétique incident absorbé, celle-ci étant induite par l'échange de chaleur local entre la capsule et l'objet.

On peut ainsi obtenir une répartition en deux dimensions des transferts thermiques entre l'objet et le capteur, et donc de la masse thermique de l'objet.

La répartition en deux dimensions des valeurs de résistances électriques des planches bolométriques constitue une image thermique de l'objet.

Dans le cas particulier d'un capteur d'empreinte papillaire, l'utilisateur pose par exemple le doigt, ou la main, sur le capteur d'empreinte selon l'invention.

Au niveau des crêtes de l'empreinte, la peau est en contact physique direct avec la surface de contact du capteur, de sorte que le transfert thermique entre la ou les capsule(s) et la peau s'effectue par conduction.

Au niveau des vallées de l'empreinte, la peau n'est pas en contact physique direct avec la surface de contact du capteur, de sorte que le transfert thermique entre la ou les capsule(s) et la peau s'effectue au mieux par convection.

Par conséquent, la variation de température au niveau des capsules est plus importante au niveau des crêtes de l'empreinte qu'au niveau des vallées de l'empreinte.

Cela se traduit par une valeur différente de la nouvelle résistance électrique de la planche bolométrique, selon que cette planche se trouve sous une crête ou sous une vallée de l'empreinte. On obtient une image de cette empreinte à partir des mesures de résistances électriques des planches bolométriques.

L'une des idées à la base de l'invention consiste, en outre, à remarquer que lorsque la surface de contact n'est pas occultée par l'objet à imager, l'environnement extérieur comprend généralement des corps rayonnant qui émettent un rayonnement électromagnétique dans l'infra-rouge.

Or, la ou les capsules(s) sont transparentes dans l'infra-rouge, de sorte que ce rayonnement atteint les planches bolométriques et affecte leurs résistances électriques.

Il peut notamment être difficile de distinguer une image de l'objet, correspondant à un objet effectivement en contact physique direct avec le capteur, d'une image non pertinente acquise lorsque l'objet s'approche de la surface de contact mais sans être encore en contact physique direct avec celle-ci.

Pour remédier à cette difficulté, l'invention propose une solution astucieuse, en recouvrant chaque capsule(s) d'un filtre optique pour arrêter un rayonnement électromagnétique dans l'infra-rouge. Ainsi, le rayonnement électromagnétique émis par le doigt ou la main ne traverse pas les capsules. Lorsque l'objet à imager n'est pas en contact direct avec la surface de contact du capteur, les planches bolométriques reçoivent toutes un même flux infrarouge qui correspond à ce qui est émis par la face intérieure d'une capsule, à la température d'équilibre. Toutes les planches bolométriques reçoivent alors un même flux infrarouge, indépendamment des conditions extérieures. L'objet ne peut être imagé que lorsqu'il est en contact direct avec la surface de contact du capteur, lorsqu'il se produit des transferts thermiques entre cet objet et l'au moins une capsule.

On comprend de manière évidente que selon l'invention, chaque planche bolométrique est donc avantageusement surmontée par un filtre optique.

Les éléments sensibles, constitués par les planches bolométriques, sont suspendus au-dessus du substrat, isolés thermiquement de ce dernier par un vide à l'intérieur de la capsule.

Chaque planche bolométrique est disposée à l'intérieur d'une capsule, qui la protège des contraintes mécaniques externes. Ainsi, le capteur selon l'invention offre à la fois une bonne isolation entre le substrat et les éléments sensibles, et une bonne tenue mécanique.

En fonctionnement, on applique l'objet à imager non pas directement sur les planches bolométriques, mais sur la surface de contact au-dessus de la ou des capsule(s), de sorte que les planches bolométriques sont protégées des contraintes en compression exercées par l'objet.

Puisque c'est la capsule qui assure la tenue mécanique du capteur, les planches bolométriques peuvent être simplement en appui vertical sur des pieds de diamètre réduit, au-dessus du substrat.

Par conséquent, un taux de remplissage surfacique par les planches bolométriques n'est pas limité par la présence de larges appuis de part et d'autre de chacune d'elles. Malgré le taux d'occupation par les parois latérales des capsules, on peut obtenir un très bon taux de remplissage surfacique par les planches bolométriques.

Selon l'invention, chaque capsule est recouverte par un filtre optique. Cela n'implique pas nécessairement que chaque filtre optique recouvre une unique capsule. Selon l'invention, chaque filtre optique s'étend donc au-dessus d'au moins une capsule.

De préférence, le capteur selon l'invention comprend une pluralité de capsules, et une unique planche bolométrique est disposée à l'intérieur de chaque capsule.

Chaque filtre optique peut être en métal.

L'impédance de chaque filtre optique est avantageusement au moins 50 fois inférieure à celle d'un vide à l'intérieur de chaque capsule.

Chaque filtre optique peut être connecté électriquement à une source de potentiel constant.

De préférence, chaque capsule présente une forme de capot dont une paroi supérieure est traversée par au moins un orifice, et dont les parois latérales et supérieure coopèrent avec une couche inférieure, et une couche supérieure, pour englober un volume fermé.

Les capsules sont avantageusement constituées de silicium amorphe ou d'un alliage comprenant du silicium amorphe. On désigne alors également par le terme « silicium amorphe », un silicium amorphe hydrogéné, dopé au germanium (Ge) et/ou au bore (B). Selon un mode de réalisation avantageux, les capsules comprennent :

- une couche externe en silicium amorphe ou un alliage comprenant du silicium amorphe ; et
- une couche interne, présentant une émissivité dans l'infra-rouge supérieure à celle de la couche externe.

Les capsules peuvent être séparées les unes des autres, sans contact physique direct entre elles.

Les filtres optiques de différentes capsules, ou lignes de capsules, peuvent être séparés les uns des autres, sans contact physique direct entre eux.

Un filtre optique s'étendant d'un seul tenant au-dessus de plusieurs capsules peut présenter des ouvertures traversantes situées entre les capsules.

Selon un mode de réalisation préférentiel, chaque filtre optique est connecté à une source de courant ou de tension de polarisation, pour l'injection d'un courant ou d'une tension adapté(e) à chauffer ledit filtre optique.

Le capteur selon l'invention comprend avantageusement des moyens de pilotage, agencés pour actionner ladite source de courant ou de tension pendant un intervalle de temps prédéterminé, et les moyens de lecture sont connectés à des moyens de comparaison, pour déterminer une variation de la résistance électrique de la planche bolométrique, entre deux instants prédéterminés.

L'invention concerne également un procédé d'utilisation d'un capteur selon ce mode de réalisation préférentiel de l'invention, dans lequel les planches bolométriques sont réparties en lignes pour former une matrice de planches bolométriques, et les filtres optiques forment des lignes chauffantes, chacune au-dessus d'une ligne de planches bolométriques, une lecture des résistances électriques des planches bolométriques étant réalisée ligne par ligne, et un chauffage des filtres optiques étant également réalisé ligne par ligne et de façon synchrone avec la lecture des résistances électriques.

**BRÈVE DESCRIPTION DES DESSINS**

La présente invention sera mieux comprise à la lecture de la description d'exemples de réalisation donnés à titre purement indicatif et nullement limitatif, en faisant référence aux dessins annexés sur lesquels :

- la figure 1 illustre un premier mode de réalisation d'un capteur d'empreinte selon l'invention, selon une vue en coupe ;
- la figure 2 illustre un deuxième mode de réalisation d'un capteur d'empreinte selon l'invention, selon une vue en coupe ;
- la figure 3 illustre un troisième mode de réalisation d'un capteur d'empreinte selon l'invention, selon une vue en coupe ;
- la figure 4 illustre un quatrième mode de réalisation d'un capteur d'empreinte selon l'invention, selon une vue en coupe ;
- la figure 5 illustre un cinquième mode de réalisation d'un capteur d'empreinte selon l'invention, selon une vue en coupe ;
- la figure 6 illustre un sixième mode de réalisation d'un capteur d'empreinte selon l'invention, selon une vue en coupe ;
- les figures 7A et 7B illustrent un septième mode de réalisation d'un capteur d'empreinte selon l'invention, et un procédé d'utilisation d'un tel capteur ; et
- les figures 8A et 8B illustrent un huitième mode de réalisation d'un capteur d'empreinte selon l'invention, et un procédé d'utilisation d'un tel capteur.

## EXPOSÉ DÉTAILLÉ DE MODES DE RÉALISATION PARTICULIERS

Dans la suite, mais de manière non limitative, on décrit plus particulièrement un capteur selon l'invention de type capteur d'empreinte digitale.

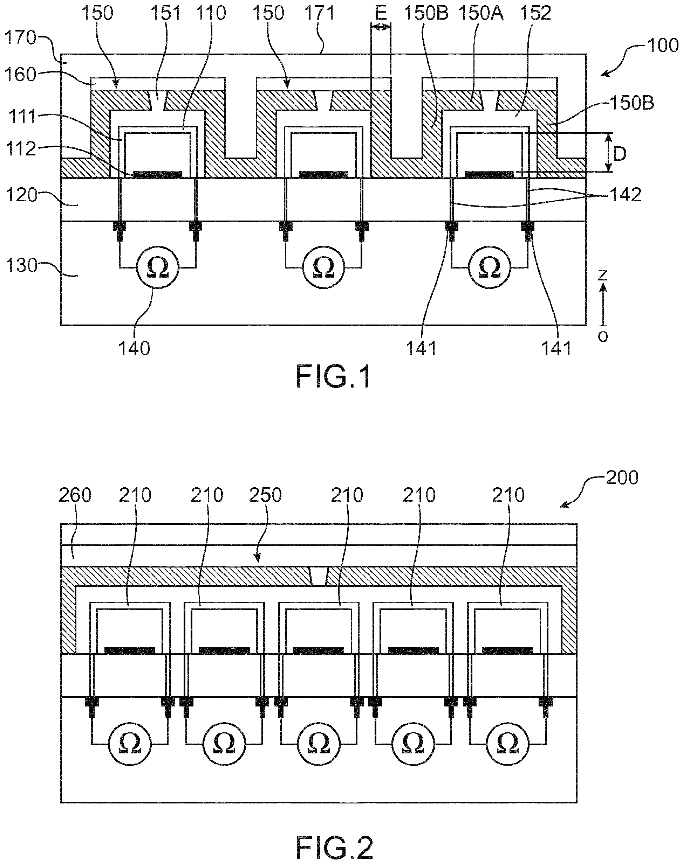

La figure 1 illustre de façon schématique un premier mode de réalisation d'un capteur d'empreinte digitale 100 selon l'invention, selon une vue en coupe.

Le capteur d'empreinte 100 est de type matriciel, c'est-à-dire constitué d'une pluralité d'éléments sensibles, répartis par exemple en lignes et colonnes.

Ces éléments sensibles sont disposés au-dessus d'un substrat 130, recouvert ici d'une couche intermédiaire 120.

Le substrat 130 est par exemple un substrat compatible avec la technologie CMOS (pour « *Complementary Metal Oxide Semiconductor* »), notamment du silicium. Cette variante est particulièrement adaptée à un capteur d'empreinte digitale, dans lequel les éléments sensibles sont répartis selon une matrice de quelques mm ou cm de côté, par exemple 8*8 mm$^2$, jusqu'à 2*3 cm$^2$.

En variante, le substrat 130 peut être un substrat compatible avec la technologie TFT (pour « *Thin-film transistor* »), notamment du verre. Cette variante est particulièrement adaptée à un capteur d'empreinte palmaire, dans lequel les éléments sensibles sont répartis selon une matrice de grandes dimensions.

Chaque élément sensible est constitué ici d'une planche bolométrique 110, en appui sur des pieds de soutien 111 au-dessus du substrat 130.

La planche bolométrique 110 comprend une membrane d'absorption, et une couche thermo-résistive qui peut être confondue avec la membrane d'absorption, ou en contact direct avec celle-ci, de préférence sur toute sa surface.

La membrane d'absorption est destinée à convertir en chaleur l'énergie d'un rayonnement électromagnétique incident, en particulier un rayonnement dans l'infrarouge moyen, à une longueur d'onde comprise entre 3 et 50 μm, et plus particulièrement autour de 10 μm, par exemple entre 5 et 20 μm ou entre 8 et 14 μm.

L'énergie absorbée chauffe la couche thermo-résistive.

La couche thermo-résistive présente une résistivité électrique qui est fonction de sa température. On mesure donc, pour chaque planche bolométrique, une résistance électrique qui varie en fonction de sa température.

En particulier, ces deux grandeurs peuvent être reliées par :

$$R(T_0 + \theta) = R(T_0) * e^{TCR*\theta}$$

avec $T_0$ la température initiale, $\theta$ la variation de température, et *TCR* le coefficient thermique de résistance de la couche thermo-résistive.

La couche thermo-résistive peut être en oxyde de vanadium, en silicium amorphe, en oxyde de titane, en oxyde de nickel, ou tout autre matériau présentant une variation de résistivité en fonction de la température.

La membrane d'absorption peut être en nitrure de titane.

La planche bolométrique 110 est suspendue au-dessus d'un réflecteur 112, adapté à réfléchir vers la planche bolométrique une part du rayonnement électromagnétique incident ayant traversé celle-ci. Ainsi, le réflecteur 112 réfléchit le rayonnement électromagnétique dans l'infra-rouge qui traverse la planche bolométrique 110 sans être directement absorbé.

Ce réflecteur 112, typiquement en métal, sert également de blindage, en formant une cage de Faraday. Il peut être connecté à la masse, ou tout autre potentiel fixe. Il peut également former une protection à l'égard des décharges électrostatiques.

Le réflecteur 112 est par exemple une fine couche métallique de cuivre ou d'aluminium, typiquement de 100 nm d'épaisseur, disposée entre le substrat 130 et la planche bolométrique, ici déposée directement sur la couche intermédiaire 120.

La distance D entre la planche bolométrique 110 et le réflecteur 112 vaut environ λ/4, où λ est la longueur d'onde centrale de l'absorption par la planche bolométrique. Par exemple λ=10 μm et D=2,5 μm. Le réflecteur 112 et la planche bolométrique 110 forment ainsi une cavité quart d'onde, réalisant une interaction additive entre l'onde transmise à travers la planche bolométrique 110 et l'onde réfléchie sur le réflecteur 112, pour maximiser une quantité d'énergie absorbée par la planche bolométrique.

Le substrat 130 reçoit un circuit de lecture de la résistance électrique de chaque planche bolométrique, et plus particulièrement chaque couche thermo-résistive. Chaque planche bolométrique est connectée électriquement à deux premiers plots de connexion 141 affleurant à la surface du substrat, par l'intermédiaire de deux vias 142 qui traversent la couche intermédiaire 120. Les deux premiers plots de connexion sont reliés à des moyens 140 de lecture d'une résistance électrique, symbolisés sur les figures par un ohmmètre.

Les premiers plots de connexion 141 sont en métal, notamment du cuivre ou de l'aluminium.

La lecture de la résistance électrique met en oeuvre une polarisation de la planche bolométrique en courant, respectivement en tension, et une mesure de tension, respectivement courant.

La planche bolométrique ne sera pas décrite ici plus avant car il s'agit d'un élément connu en soi, dans le domaine de la détection infra-rouge.

Chaque planche bolométrique est suspendue dans un vide, à l'intérieur d'une capsule 150.

On entend par vide un milieu gazeux raréfié en gaz, présentant une pression inférieure à 10$^{-3}$ mbar.

Dans l'exemple représenté en figure 1, chaque capsule 150 englobe une unique planche bolométrique 110.

Les capsules sont des structures tridimensionnelles, fermées hermétiquement et mises sous vide pendant un procédé de scellement.

Chaque capsule 150 présente une forme de capot entourant une cavité 152. Le capot est constitué de parois latérales 150B, coiffées par une paroi supérieure 150A.

Dans tout le texte, les termes « supérieur » et « inférieur » se rapportent à un axe vertical (Oz), orthogonal au substrat, et orienté du substrat vers les capsules.

Dans l'exemple représenté en figure 1, la capsule coopère avec une couche inférieure sur laquelle elle repose, ici la couche intermédiaire 120, pour définir la cavité 152, formant un volume fermé et scellé sous vide.

La paroi supérieure 150A est percée par au moins un orifice 151 ou évent, permettant d'évacuer une couche sacrificielle utilisée pour fabriquer la capsule. Cet orifice 151 est fermé hermétiquement par une couche recouvrant les capsules.

Sur les figures, l'orifice 151 est représenté au centre de la paroi supérieure 150A. L'orifice peut cependant être positionné ailleurs sur la capsule. Il peut également y avoir plusieurs orifices par capsule.

Selon un mode de réalisation préféré, les parois latérales 150B s'étendent sensiblement verticales, parallèles à l'axe (Oz). Elles présentent une hauteur constante selon (Oz). La paroi supérieure 150A est une paroi plane, qui s'étend dans un plan horizontal, orthogonale à l'axe (Oz). Elle est en contact physique direct sur tout son périmètre, avec les bords supérieurs des parois latérales 150B.

La paroi supérieure 150A présente ici une forme carrée, les parois latérales présentent une forme de cylindre à base carré, et la capsule entoure une cavité 152 en forme de parallélépipède rectangle.

Chaque cavité 152 peut enfermer un matériau getter, pour conserver la qualité du vide dans le temps. Un matériau getter, ou piège à gaz, limite l'apparition de gaz dans une enceinte. Il peut s'agir d'un métal facilement oxydable tel que du titane, ou du vanadium, du zirconium, du cobalt, du fer, du manganèse, de l'aluminium ou un alliage de ces métaux.

Dans l'exemple illustré en figure 1, toutes les capsules sont formées d'un seul tenant, reliées entre elles du côté inférieur de leurs parois latérales respectives, par des régions périphériques qui s'étendent directement sur le substrat.

Grâce au vide à l'intérieur des capsules, les planches bolométriques 110 n'échangent pas de chaleur avec leur milieu environnant par conduction ou convexion. Elles ne sont donc sensibles qu'à un rayonnement infrarouge incident, émis ici par les faces internes des capsules 150.

Afin de limiter encore les éventuels échanges de chaleur autrement que par rayonnement entre les planches bolométriques et leur environnement, les pieds de soutien 111 sur lesquels reposent les planches bolométriques occupent moins d'un dixième de la surface des planches bolométriques. Les pieds de soutien 111, nommés clous, ou plugs, présentent de préférence seulement quelques centaines de nanomètres de diamètre.

En outre, le vide sous les capsules isole thermiquement le substrat et les parois supérieures 150A des capsules. On limite ainsi des transferts thermiques impliquant les capsules et n'impliquant pas l'objet appliqué sur la surface de contact.

Dans l'exemple représenté en figure 1, les capsules reposent sur une couche intermédiaire 120.

La couche intermédiaire 120 est une couche barrière à la gravure d'une couche sacrificielle, déposée lors du procédé de fabrication des capsules et/ou lors du procédé de fabrication des planches bolométriques suspendues.

La couche intermédiaire 120 est par exemple en SiC, AlN, $Al_2O_3$, SiN, SiO, SiON, SiC, etc.

Elle peut également présenter des capacités d'isolant thermique, pour améliorer l'isolation thermique entre le substrat et les capsules. Elle peut présenter une faible conductivité thermique, par exemple inférieure à 5 $W.m^{-1}.K^{-1}$, et même inférieure à 2 $W.m^{-1}.K^{-1}$, voire à 1 $W.m^{-1}.K^{-1}$.

La couche 120 est optionnelle, notamment lorsque le substrat est en verre.

Selon une variante non représentée, le substrat est séparé des capsules par deux couches, l'une dédiée plus spécifiquement à l'isolation thermique des capsules, l'autre dédiée plus spécifiquement à l'arrêt de la gravure de la couche sacrificielle.

Les capsules 150 sont avantageusement en contact direct avec la couche intermédiaire 120.

Le cas échéant, une fine couche d'accroche peut être déposée sur la couche intermédiaire.

La fine couche d'accroche comprend par exemple du titane ou du tantale, par exemple du TiN, Ti/TiN, TaN, ou Ta/TaN.

Dans des variantes dans lesquelles on chauffe les capsules (par l'intermédiaire des filtres optiques métalliques, voir plus loin), il peut être avantageux de s'assurer que la fine couche d'accroche ne court-circuite pas les capsules (choix d'une couche d'accroche isolante électriquement, ou texturation adaptée de celle-ci pour éviter de passer au-dessus de plots de connexion).

Les capsules sont par exemple en silicium amorphe (a-Si), notamment du silicium amorphe hydrogéné (a-Si :H) pouvant être dopé, par exemple par des atomes de bore ou de germanium. Ce matériau présente notamment une bonne résistance mécanique. En outre, c'est un matériau conforme permettant que les grandes discontinuités géométriques liées à la forme de capsule n'impliquent pas de discontinuité électrique. Il est compatible avec les technologies standards TFT et CMOS.

En variante, le silicium amorphe est mélangé avec un autre composant au sein d'un alliage. On peut utiliser par exemple du silicium amorphe hydrogéné (a-Si :H), par exemple a-Si$_x$Ge$_y$B$_z$ :H, notamment a-SiGe :H ou a-SiGeB :H.

Chaque capsule est recouverte d'un filtre optique dédié, ou d'une portion d'un filtre optique recouvrant plusieurs capsules.

Ici, chaque filtre optique 160 recouvre la paroi supérieure 150A d'une unique capsule 150.

Ainsi, et comme illustré sur la figure 1, chaque planche bolométrique 110 se trouve surmontée par un filtre optique 160.

Chaque filtre optique 160 est un filtre optique infrarouge.

Il présente des propriétés de filtre infrarouge et de conducteur thermique.

Il arrête un rayonnement électromagnétique susceptible de chauffer les planches bolométriques s'il pouvait traverser les capsules, notamment un rayonnement dans l'infrarouge moyen, à une longueur d'onde comprise entre 5 et 20 $\mu$m, et plus particulièrement entre 8 et 14 $\mu$m.

Il s'agit par exemple d'un réflecteur, qui réfléchit un rayonnement électromagnétique vers l'extérieur du capteur d'empreinte 100.

En revanche, le filtre infrarouge 160 transmet par conduction la chaleur transmise par un corps en contact avec celui-ci.

Il est formé par exemple par une couche métallique 160.

Les fonctions de filtrage de l'infrarouge et de conduction de la chaleur peuvent également être réalisées par un matériau non métallique.

Le filtre infrarouge 160 est par exemple en titane, aluminium, platine, nickel, or, cuivre, nitrure de titane (TiN), ou un alliage tel que Ti/TiN ou Ti/Al.

Le filtre infrarouge 160 peut présenter un coefficient de réflexion supérieur à 70% à 10 $\mu$m, et une bonne conductivité thermique, par exemple au moins 20 W·m$^{-1}$·K$^{-1}$ à 20°C à la pression atmosphérique.

Il présente de préférence une impédance désadaptée relativement à l'impédance d'un vide à l'intérieur des capsules.

Par exemple, les planches bolométriques sont suspendues dans un vide, d'impédance 377 $\Omega$, et le filtre infrarouge présente une impédance inférieure à 5 $\Omega$. On limite ainsi l'absorption par le filtre du rayonnement infrarouge incident sur celui-ci. On évite ainsi que ce rayonnement infrarouge chauffe le filtre.

Le filtre infrarouge 160 peut également permettre de fermer les orifices 151, par exemple pour fermer hermétiquement les capsules sous vide.

En variante, les orifices 151 sont fermés par une couche distincte du filtre infrarouge, par exemple une couche de germanium, et le filtre optique s'étend sur cette couche distincte.

Les filtres infrarouge 160 sont recouverts d'une couche de protection 170, pour protéger les capsules à l'égard de contacts répétés avec des tissus humains.

Une face externe de la couche de protection 170, au-dessus des capsules, forme une surface de contact 171 du capteur d'empreinte.

L'épaisseur et la conductivité thermique de la couche de protection sont adaptées pour assurer à la fois un bon transfert thermique entre le doigt et les capsules, et pour limiter une diffusion latérale de la chaleur.

La couche de protection peut être constituée d'une couche d'oxyde épaisse, d'une couche d'un polymère époxyde (peinture époxy), d'une couche de carbone amorphe dite DLC (pour « Diamond-Like Carbon »), etc.

Elle présente avantageusement une épaisseur inférieure à 30 $\mu$m, et même inférieure à 20 $\mu$m, voire inférieure à 1 $\mu$m pour du DLC.

En variante, une couche formant un filtre infrarouge présente également une fonction de protection à l'égard de contacts répétés avec des tissus humains, ce qui permet de s'affranchir d'une couche de protection spécifique.

En fonctionnement, l'utilisateur approche son doigt de la surface de contact 171. Le doigt émet un rayonnement électromagnétique, qui est arrêté par le filtre infrarouge 160.

Lorsque le doigt est posé sur le capteur d'empreinte digitale, en contact physique direct avec la surface de contact 171, la peau est alors en contact direct avec la surface de contact 171, au niveau des crêtes de l'empreinte digitale, où se produit un échange thermique avec les capsules 150, à travers le filtre infrarouge 160.

Cet échange de chaleur entraîne une variation de la température des capsules, et donc une modification de la puissance d'un rayonnement électromagnétique dans l'infrarouge, émis vers l'intérieur des capsules et en direction des planches bolométriques.

Cette modification du rayonnement électromagnétique entraîne à son tour une modification de la température des planches bolométriques, et donc de leurs résistances électriques.

Ainsi, les planches bolométriques situées sous une crête de l'empreinte prennent une première valeur de résistance électrique, mesurée par les moyens 140 de lecture d'une résistance électrique.

Au niveau des vallées de l'empreinte digitale, l'absence de contact physique direct entraîne un échange thermique moins important entre le doigt et les capsules, qui se traduit par une valeur différente des résistances électriques des planches bolométriques situées en-dessous.

Chaque valeur de résistance d'une planche bolométrique peut être convertie en niveau de gris, par des moyens de conversion non représentés, pour former une image de l'empreinte digitale.

Ce type de détection est nommé « détection en thermique passif ».

De préférence, il est utilisé conjointement avec un balayage du doigt sur la surface de contact 171, pour retarder l'apparition d'un équilibre thermique au niveau des capsules, entraînant une baisse de contraste de l'image de l'empreinte.

Les parois 150A et 150B des capsules 150 peuvent présenter une épaisseur E d'environ 1 μm, par exemple comprise entre 0,5 et 2 μm, qui suffit à conférer une bonne résistance mécanique à la capsule.

De telles capsules présentent une grande stabilité mécanique, notamment à l'égard des contraintes en pression qui peuvent s'exercer lorsqu'un utilisateur appuie le doigt sur la surface de contact du capteur.

La distance entre la paroi supérieure 150A de la capsule, et la planche bolométrique, peut être inférieure à 2 μm, et même 1 μm, par exemple comprise entre 600 et 800 nm. Ainsi, l'efficacité du transfert d'énergie entre la capsule et la planche bolométrique est optimisée.

Chaque capsule peut présenter des dimensions réduites, de sorte que les capsules soient réparties selon un pas de répétition réduit, notamment inférieur à 51 μm, par exemple 50,8 μm ou 25,4 μm. On réalise également un capteur d'empreinte présentant une très bonne fonction de transfert de modulation.

Les capsules peuvent être disposées très proches les unes des autres. Par exemple, deux capsules voisines peuvent être espacées de seulement quelques centaines de nanomètres l'une de l'autre.

En outre, si une capsule est électriquement conductrice, elle forme un blindage contre les parasites électrostatiques, notamment autour de 50Hz, apportés par le contact avec la peau lorsque le doigt touche la surface de contact du capteur. Elle permet ainsi de limiter le bruit injecté par liaison capacitive entre la peau et les éléments sensibles du capteur.

Les planches bolométriques définissent ensemble une surface de détection du capteur d'empreinte.

A l'intérieur de chaque capsule, la planche bolométrique peut s'étendre sur une large surface, de sorte que le capteur peut présenter un bon taux de remplissage surfacique de la surface de détection, par les planches bolométriques, par exemple supérieur à 0,6, ou 0,8.

En pratique, le capteur d'empreinte 100 peut être réalisé à l'aide des étapes suivantes :

- de préférence, dépôt sur le substrat de la couche intermédiaire 120, présentant une fonction d'arrêt de la gravure (pour protéger le substrat lors de l'évacuation des plots sacrificiels) ;
- construction des planches bolométriques suspendues au-dessus de la couche intermédiaire 120, à l'aide d'une première couche sacrificielle, organique (par exemple du polyimide) ou minérale (par exemple de l'oxyde de silicium) puis d'une évacuation de cette première couche sacrificielle ;
- dépôt d'une seconde couche sacrificielle recouvrant et noyant les planches bolométriques ;
- gravures locales de la seconde couche sacrificielle pour former des plots sacrificiels autour des planches bolométriques ;

- dépôt du matériau des capsules, sur et entre les plots sacrificiels, pour former la matrice de capsules ;
- gravure locale du matériau des capsules, pour former les orifices 151 ;
- évacuation du matériau des plots sacrificiels, en passant par les orifices 111 ;
- dépôt du filtre infrarouge 160 ;
- dépôt de la couche de protection 170.

L'homme du métier saura si besoin trouver plus de détails sur les premières étapes du procédé de fabrication, en se référant au domaine de la détection infrarouge, voir par exemple document EP 2 466 283.

Ces procédés de l'art antérieur peuvent être nommés « pixel level packaging ». Ils ne comprennent pas d'étape de dépôt d'un filtre infrarouge. Selon ces procédés, on cherche au contraire à maximiser le taux de transmission de l'infrarouge à travers les capsules.

Ici, la seconde couche sacrificielle est gravée partout, excepté aux emplacements destinés à former les cavités 152.

Le matériau des capsules est déposé, à épaisseur sensiblement constante, sur l'ensemble des surfaces latérales et supérieures des plots sacrificiels, et entre deux plots sacrificiels.

La première et la seconde couches sacrificielles peuvent être en matériau organique. Il peut s'agir d'un polymère, notamment un polymère organique comme le polyimide. Les plots sacrificiels peuvent alors être évacués par gravure par plasma d'oxygène.

En particulier, on peut réaliser un capteur d'empreinte compatible avec la technologie TFT, sur un substrat verre, en réalisant les capsules à l'aide d'une première puis d'une seconde couches sacrificielles polymères (par exemple en polyimide), évacuées ensuite par gravure par plasma d'oxygène, et d'un dépôt PECVD de matériau thermo-résistif.

De préférence, le substrat 130 est protégé par la couche intermédiaire 120 d'arrêt de la gravure, résistante à la gravure par plasma d'oxygène, par exemple en SiN, SiO, $SiO_2$, SiON, SiC, etc.

En variante, on peut s'affranchir d'une couche d'arrêt de la gravure, une couche de passivation, intrinsèque au substrat, pouvant le protéger et servir de barrière à la gravure par plasma d'oxygène. Cette couche de passivation, non représentée sur les figures, est par exemple en $SiN_x$ ou $SiO_x$.

En variante, la première et la seconde couches sacrificielles peuvent être en matériau minéral. Il peut s'agir d'un oxyde, par exemple de l'oxyde de silicium. Les plots sacrificiels peuvent alors être évacués par gravure HF (acide fluorhydrique).

Dans ce cas, il est nécessaire de protéger le substrat 130 par une couche intermédiaire 120 d'arrêt de la gravure.

Pour une couche sacrificielle minérale (par exemple $SiO_2$) avec gravure HF, la couche d'arrêt de la gravure 120 peut être de l'AlN, de l'$Al_2O_3$, du SiC, du

carbone amorphe, du DLC et éventuellement du polyimide.

L'épaisseur de cette couche est comprise entre 20 et 200nm, préférentiellement 50nm.

En particulier, on peut réaliser un capteur d'empreinte compatible avec la technologie CMOS, en réalisant les capsules à l'aide d'une première puis d'une seconde couches sacrificielles minérales, évacuées ensuite par gravure HF, et d'un dépôt CVD de matériau thermo-résistif.

Le document EP 2 743 659 décrit, dans un autre contexte, un exemple d'un procédé utilisant une couche sacrificielle évacuée ensuite par gravure HF.

Le matériau des capsules peut être déposé par dépôt chimique en phase vapeur (CVD), en particulier lorsque le capteur d'empreinte est réalisé en technologie CMOS, ou par dépôt chimique en phase vapeur assisté par plasma (PECVD), en particulier lorsque le capteur d'empreinte est réalisé en technologie TFT, ou par dépôt physique par phase vapeur (PVD).

La figure 2 illustre de manière schématique un deuxième mode de réalisation de capteur d'empreinte 200 selon l'invention.

Le mode de réalisation de la figure 2 ne sera décrit que pour ses différences relativement au mode de réalisation de la figure 1.

Dans ce second mode de réalisation, une unique capsule 250 est scellée sous vide, en enfermant l'ensemble des planches bolométriques 210 du capteur d'empreinte 200.

On parle de macro-capsule.

Cette macro-capsule est renforcée localement par des piliers qui s'étendent entre les planches bolométriques, pour assurer sa stabilité mécanique.

Elle permet de diminuer l'espace entre deux planches bolométriques, pour augmenter encore un facteur de remplissage de la surface de détection par les éléments sensibles du capteur.

En revanche, elle présente un cross talk thermique important entre les pixels du capteur, puisque c'est une même et unique paroi supérieure de capsule qui réalise des échanges thermiques avec l'objet en appui sur la surface de contact.

Ici, un unique filtre optique 260 s'étend au-dessus de toutes les planches bolométriques, au-dessus de la macro-capsule 250.

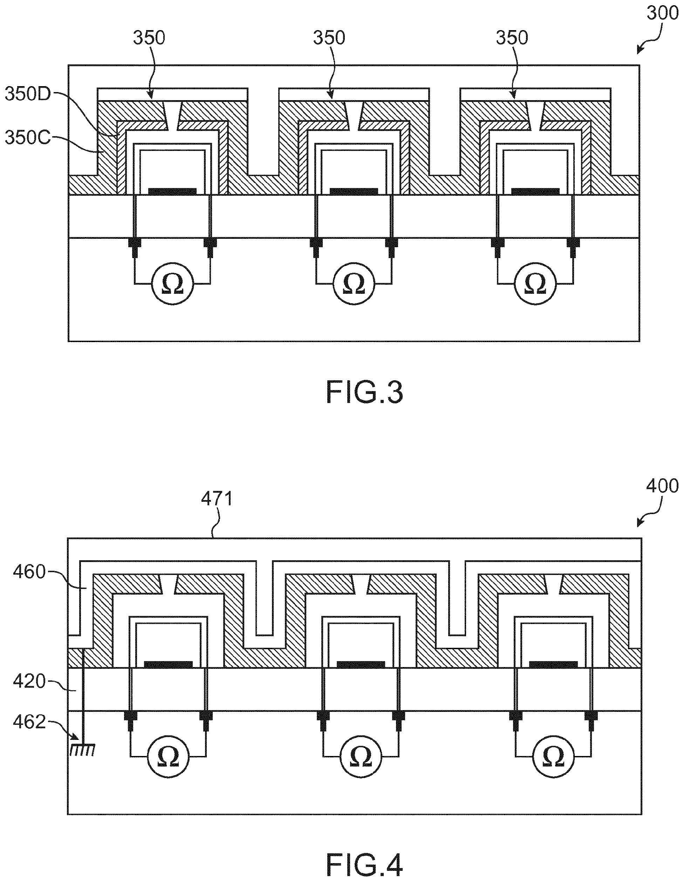

La figure 3 illustre de manière schématique un troisième mode de réalisation de capteur d'empreinte 300 selon l'invention.

Le mode de réalisation de la figure 3 ne sera décrit que pour ses différences relativement au mode de réalisation de la figure 1.

Dans ce mode de réalisation, l'émissivité dans l'infrarouge des capsules 350 est améliorée, grâce à des parois internes en matériau fortement émissif dans la gamme infrarouge.

En particulier, chaque capsule 350 est constituée par une couche externe 350C, assurant la tenue mécanique des capsules, et une couche interne 350D, dédiée plus spécifiquement à l'émission d'un rayonnement électromagnétique dans l'infrarouge, vers les planches bolométriques.

Les couches externes 350C correspondent à la description des capsules, donnée en référence à la figure 1.

Chaque couche interne 350D recouvre directement au moins une partie de la couche externe 350C, du côté intérieur de la capsule.

Chaque couche interne 350D recouvre notamment, côté intérieur de la capsule, la paroi supérieure de la couche interne 350C, et le cas échéant ses parois latérales.

La couche interne 350D présente une forte émissivité dans l'infrarouge, supérieure à celle de la couche externe 350C.

La couche interne 350D peut comprendre, voire être constituée par :

- un nitrure (en particulier le nitrure de titane TiN, mais également un nitrure tel que : SiN, $Si_3N_4$, AIN, WN, $W_2N$), la couche interne pouvant par exemple être constituée d'un nitrure seul ou d'un alliage comprenant un nitrure (notamment Ti/TiN) ;
- un matériau à base de carbone tel que le graphite (le graphène étant de préférence exclu) ;
- un oxyde tel que $SiO_2$, $SiO_x$ ; etc.

Ce mode de réalisation peut être obtenu à l'aide de deux dépôts successifs sur les plots sacrificiels tels que mentionnés ci-avant, pour déposer d'abord le matériau de la couche interne 350D, puis le matériau de la couche externe 350C.

La figure 4 illustre de manière schématique un quatrième mode de réalisation de capteur d'empreinte 400 selon l'invention.

Le mode de réalisation de la figure 4 ne sera décrit que pour ses différences relativement au mode de réalisation de la figure 1.

Dans ce mode de réalisation, la couche métallique formant le filtre infrarouge 460 s'étend d'un seul tenant au-dessus de plusieurs capsules, et est connectée à un potentiel constant, pour former une protection à l'égard des accumulations de charges électrostatiques.

Des charges peuvent s'accumuler lorsque le doigt est en contact avec la surface de contact 471 du capteur d'empreinte, jusqu'à provoquer une décharge électrostatique.

Les décharges électrostatiques peuvent, à terme, détériorer le capteur d'empreinte et notamment les planches bolométriques.

Ici, la couche métallique est simplement connectée à la masse 462, par un via qui traverse la couche intermédiaire 420 et le matériau des capsules.

En variante, le capteur comprend une couche métallique annexe, au-dessus du ou des filtre(s) infrarouge(s), dédiée uniquement à la protection à l'égard des décharges électrostatiques.

Bien que le filtre métallique 460 recouvre plusieurs capsules, de préférence il ne remplit pas l'espace entre les capsules, pour limiter les échanges thermiques entre les capsules.

Selon une variante non représentée, le filtre métallique 460 présente des ouvertures traversantes entre les capsules, pour limiter encore les échanges thermiques entre les capsules.

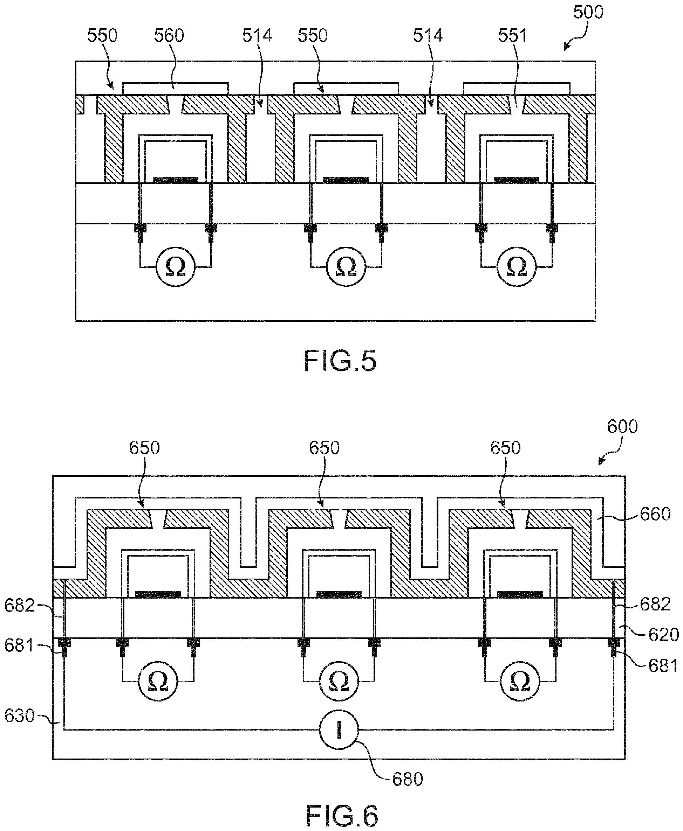

La figure 5 illustre de manière schématique un cinquième mode de réalisation de capteur d'empreinte 500 selon l'invention.

Le mode de réalisation de la figure 5 ne sera décrit que pour ses différences relativement au mode de réalisation de la figure 1.

Dans ce mode de réalisation, les capsules 550 sont séparées physiquement les unes des autres, sans contact physique entre elles. Elles sont ainsi isolées thermiquement et électriquement les unes des autres, ce qui améliore le contraste d'une image de l'empreinte obtenue à l'aide du capteur d'empreinte 500 selon l'invention.

Ici, le matériau des capsules ne s'étend pas entre les capsules, du côté du substrat. En revanche, le matériau des capsules s'étend également entre les capsules, à même hauteur et même épaisseur que leurs parois supérieures respectives. Des tranchées 514 s'étendent dans ce matériau, entre les capsules, pour isoler les capsules les unes des autres.

De préférence, les tranchées 514 séparant les capsules forment ensemble une grille constituée d'une première série de tranchées parallèles, sécante avec une seconde série de tranchées parallèles.

En pratique, on peut réaliser une matrice de capsules isolées physiquement les unes des autres à l'aide du procédé décrit ci-avant, dans lequel :

- la seconde couche sacrificielle est gravée partout, excepté autour des planches bolométriques, et aux emplacements destinés à former les espaces de séparation entre les capsules, pour former des plots sacrificiels ;
- le matériau des capsules est déposé dans les interstices entre les plots sacrificiels, et au-dessus de ces derniers ;
- le matériau des capsules est gravé localement pour former les orifices 551 dans les capsules 550, et les tranchées 514 entre les capsules ; et
- on évacue les plots sacrificiels en passant par les orifices 551, respectivement les tranchées 514.

Les plots sacrificiels aux emplacements destinés à former les espaces de séparation entre les capsules peuvent former ensemble une grille, avec, dans chaque trou de la grille, un plot sacrificiel entourant une planche bolométrique.

Ce procédé est particulièrement avantageux puisque la séparation des capsules est réalisée dans une même étape technologique que la gravure des orifices dans les capsules.

En variante, le capteur d'empreinte ne diffère du capteur de la figure 1 qu'en ce que les portions du matériau thermo-résistif entre les capsules, côté substrat, sont ouvertes par des tranchées séparant des capsules voisines.

Ici, chaque capsule est séparée des autres capsules. En variante, les capsules sont formées d'un seul tenant en rangées de capsules, séparées physiquement des autres rangées de capsules.

Dans l'exemple représenté en figure 5, chaque capsule 550 est surmontée par un filtre optique distinct 560, séparé physiquement des autres filtres optiques 560, sans contact physique entre eux.

En variante, chaque filtre optique peut s'étendre d'un seul tenant au-dessus d'une rangée de capsules, séparé physiquement des autres filtres optiques s'étendant au-dessus d'une autre rangée de capsules.

En tout état de cause, comme illustré sur la figure 5, et comme dans le mode de réalisation de la figure 1, chaque planche bolométrique se trouve surmontée par un filtre optique 560.

La figure 6 illustre de manière schématique un sixième mode de réalisation de capteur d'empreinte 600 selon l'invention.

Le mode de réalisation de la figure 6 ne sera décrit que pour ses différences relativement au mode de réalisation de la figure 1.

Dans ce mode de réalisation, le filtre infrarouge 660 est une couche métallique connectée à une source de courant 680 (ou de tension), pour l'injection d'un courant de polarisation (ou d'une tension de polarisation) adapté(e) à chauffer ladite couche métallique.

Ici, la source de courant (ou de tension) 680 est intégrée au substrat 630. Le courant circule successivement dans un second plot de connexion 681, affleurant à la surface supérieure du substrat, puis dans un via 682, à travers la couche intermédiaire 620 et le matériau des capsules, puis dans la couche métallique 660, puis dans un autre via 682 et un autre second plot de connexion 681.

Le courant de polarisation (ou la tension de polarisation) chauffe la couche métallique 660, par effet Joule.

Cette chaleur est transmise par conduction aux capsules.

On peut ainsi améliorer un contraste de l'image de l'empreinte, et le rapport signal sur bruit de cette image, dans le cadre d'une détection de type thermique passif, lorsque la température initiale des capsules est trop proche de la température du doigt.

On peut également éviter une saturation du capteur, si cette différence de température est trop élevée.

En pratique, on peut ne mettre en oeuvre le chauffage que pour une seconde acquisition, si la première acquisition n'offre pas un contraste suffisant.

On peut également utiliser ce chauffage d'un filtre optique, pour modifier son impédance et ainsi amplifier une désadaptation d'impédance avec un vide à l'intérieur des capsules, en exploitant des propriétés de thermo-résistivité du filtre optique.

Là encore, comme représenté par la figure 6, chaque planche bolométrique se trouve surmontée par le filtre optique 660.

Ce mode de réalisation peut être combiné au mode de réalisation dans lequel le filtre infrarouge métallique est connecté à un potentiel constant, pour former une protection à l'égard des accumulations de charges électrostatiques (voir notamment figure 4).

Par exemple, le filtre infrarouge métallique peut être connecté à un dispositif à interrupteur, pour basculer entre deux modes. On peut ainsi connecter ledit filtre à une source de potentiel constant, lors d'une phase initiale de mise en contact d'une empreinte (ou autre objet) avec la surface de contact du capteur (premier mode). On peut ensuite connecter ledit filtre à une source de courant ou de tension pour l'injection d'un courant ou d'une tension de polarisation destiné(e) à chauffer le filtre métallique (second mode). Un détecteur de présence peut permettre le basculement d'un mode à l'autre.

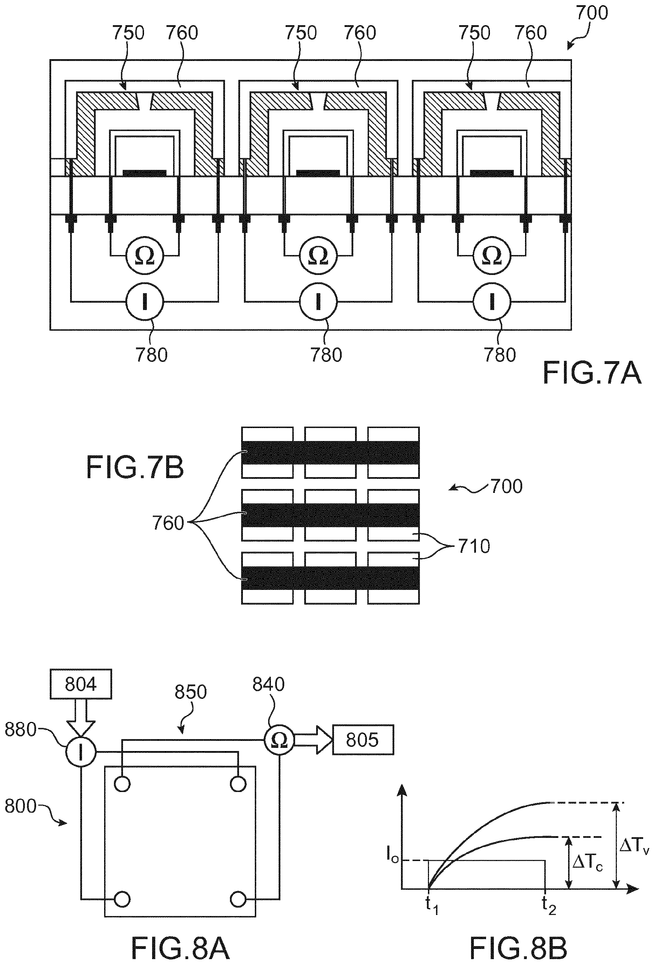

Les figures 7A et 7B illustrent de manière schématique un septième mode de réalisation de capteur d'empreinte 700 selon l'invention.

Le mode de réalisation de la figure 7A ne sera décrit que pour ses différences relativement au mode de réalisation de la figure 1.

Là encore, comme représenté par la figure 7A, chaque planche bolométrique se trouve surmontée par un filtre optique 760.

Dans ce mode de réalisation, les filtres optiques forment ensemble des bandes chauffantes.

La figure 7B représente de façon schématique le capteur d'empreinte 700, selon une vue de dessus. On voit que les capsules 750 sont réparties selon un maillage carré. Elles forment ensemble une matrice de capsules, dans laquelle chaque capsule reçoit un bolomètre.

La largeur de la matrice de capsule désigne l'une de ses dimensions dans un plan parallèle au substrat. Ce n'est pas forcément la plus grande dimension.

Les filtres optiques surmontant les capsules sont formés ici par des bandes métalliques 760 parallèles entre elles, qui s'étendent chacune sur toute la largeur de la matrice de capsules. En d'autres termes, chaque bande métallique 760 surmonte une rangée de capsules 750.

Chaque bande métallique 760 est connectée à une source de courant (ou de tension) 780, du type de la source décrite en référence à la figure 6.

Chaque bande métallique 760 forme une bande chauffante, pour chauffer la ligne de capsules située en-dessous.

En fonctionnement, toutes les bandes chauffantes ne sont pas forcément actionnées en même temps.

Cela permet de restreindre une puissance électrique maximale à fournir au capteur d'empreinte 600.

En outre, on peut intégrer successivement les signaux électriques des différentes lignes de bolomètres, et ne chauffer que la bande chauffante au-dessus de la ligne de bolomètres dont on intègre les signaux. On lit ensuite une ligne de bolomètres, pendant que le signal est intégré sur la ligne suivante.

On restreint ainsi la consommation énergétique du capteur 600.

En particulier, les signaux électriques des lignes de planches bolométriques associées à la matrice de capsules sont intégrés une ligne après l'autre, de bas en haut (ou de haut en bas). De la même façon, les bandes chauffantes sont activées les unes après les autres, de bas en haut (ou de haut en bas), et de façon synchrone avec l'intégration des signaux électriques des lignes de planches bolométriques.

En variante, chaque capsule est surmontée par un filtre optique distinct, séparé physiquement des autres filtres optiques, sans contact physique entre eux, et chaque filtre optique peut être chauffé individuellement.

Le chauffage est optimal, car la source de chaleur, ici le filtre optique, est située entre les capsules et le doigt.

Comme détaillé ci-avant, lorsque le doigt est posé sur le capteur, chaque capsule échange plus ou moins de chaleur avec le doigt selon qu'elle est surmontée par une crête ou par une vallée de l'empreinte, l'échange de chaleur modifiant la température de la capsule et donc la puissance du rayonnement électromagnétique émis et détecté par les planches bolométriques.

Cependant, après un certain temps, la température du capteur peut s'homogénéiser, de sorte que la différence de température entre une capsule associée aux crêtes et une capsule associée aux vallées de l'empreinte diminue. Il s'ensuit une perte de contraste sur l'image de l'empreinte.

Afin de remédier à cela, on peut chauffer les capsules, notamment par l'intermédiaire du filtre optique situé au-dessus.

Comme détaillé ci-avant, il va se produire un échange thermique entre le doigt et les capsules, plus ou plus important selon que la capsule est surmontée par une crête ou par une vallée de l'empreinte.

En particulier, il peut s'agir d'un échange de chaleur par conduction, lorsqu'il y a contact direct entre les tissus de la peau et la surface de contact, au niveau des crêtes de l'empreinte.

En variante, il s'agit d'un échange de chaleur par convection, au niveau des vallées de l'empreinte.

L'échange de chaleur étant plus efficace par conduction que par convection, la variation de la température de chaque capsule varie, selon qu'elle se trouve sous une crête ou sous une vallée de l'empreinte.

En mesurant une variation de la résistance électrique associée à une capsule, au cours d'un intervalle de temps prédéterminé, on peut savoir si elle est surmontée par une crête ou une vallée d'une empreinte digitale.

Le chauffage des capsules permet de briser l'équilibre thermodynamique qui peut s'établir au sein du capteur d'empreinte, pour conserver une image contrastée de l'empreinte.

Ce type de détection peut être nommé «mode de détection actif». Il utilise des mesures de variations de résistances électriques, couplées à un chauffage des éléments sensibles.

Les figures 8A et 8B illustrent de manière schématique un huitième mode de réalisation de capteur d'empreinte selon l'invention, adapté à la mise en oeuvre d'une détection de type thermique actif.

La figure 8A représente schématiquement une capsule 850, selon une vue de dessus. La capsule 850 est chauffée indirectement par une source de courant (ou de tension) 880, qui chauffe le filtre optique surmontant ladite capsule. La résistance électrique de la planche bolométrique, sous la capsule 850, est lue par des moyens 840 de lecture de résistance électrique.

La source 880 est reliée à des moyens de pilotage 804, pour actionner l'injection d'un courant (ou d'une tension) pendant un intervalle de temps prédéterminé.

La figure 8B illustre une impulsion de courant fournie par la source de courant 880 (courant constant $I_0$ entre les instants $t_1$ et $t_2$, et nul ailleurs).

Cette impulsion de courant fournit à la capsule, via le filtre optique correspondant, une quantité constante de chaleur, entre les instants $t_1$ et $t_2$ (voir figure 8B).

Lorsque la capsule est recouverte par une vallée de l'empreinte, la chaleur est transmise au doigt par convection. L'efficacité de ce transfert de chaleur est moindre, de sorte que la température de la capsule augmente fortement entre les instants $t_1$ et $t_2$ (variation de température $\Delta T_v$, voir figure 8B).

Lorsque la capsule est recouverte par une crête de l'empreinte, la chaleur est transmise au doigt par conduction. L'efficacité de ce transfert de chaleur est grande, de sorte que la température de la capsule augmente faiblement entre les instants $t_1$ et $t_2$ (variation de température $\Delta T_c < \Delta T_v$).

Ces variations de température correspondent à des variations d'intensité du rayonnement électromagnétique émis vers les planches bolométriques, et finalement par des variations de résistances électriques mesurées au niveau des planches bolométriques.

Les moyens 840 de lecture de la résistance électrique de la planche bolométrique sont donc reliés à des moyens de comparaison 805, pour mesurer une variation de la résistance électrique de la planche bolométrique entre deux instants, notamment entre l'instant de démarrage du chauffage de la capsule, et l'instant de fin de ce chauffage, ici entre $t_1$ et $t_2$.

On peut convertir ladite variation de résistance électrique en niveau de gris, pour former une image de l'empreinte digitale.

Cette détection peut être mise en oeuvre avec des filtres optiques associés chacun à une capsule et séparés physiquement les uns des autres, ou avec des filtres optiques formant ensemble des bandes chauffantes, comme décrit en référence aux figures 7A et 7B, ou même avec un filtre optique formés d'un seul tenant au-dessus de toute la matrice de capsules.

Cette détection peut également être combinée avec le chauffage et la lecture de résistances synchrones.

L'invention n'est pas limitée aux exemples décrits, et on pourra réaliser de nombreuses variantes des modes de réalisation décrits ci-dessus, sans sortir du cadre de l'invention.

Par exemple, les capsules peuvent être réparties selon une unique ligne de capsules, le doigt (respectivement la main) étant déplacé(e) au-dessus de cette ligne de capsules pour détecter toute l'empreinte. En variante, c'est le capteur linéaire qui est déplacé relativement à la main ou au doigt restant fixe. Dans ce cas, le chauffage des capsules n'est pas forcément utile.

## Revendications

**1.** Capteur (100 ; 200 ; 300 ; 400 ; 500 ; 600 ; 700) de motifs thermiques d'un objet, en particulier une empreinte papillaire, comprenant une surface de contact (171; 471) pour y appliquer l'objet à imager, **caractérisé en ce qu'**il comprend :

  - au moins une capsule (150 ; 250 ; 350 ; 550 ; 650 ; 750 ; 850) scellée sous vide, disposée entre un substrat (130 ; 630) et ladite surface de contact, adaptée à échanger de la chaleur par conduction avec l'objet à imager et à émettre un rayonnement électromagnétique en fonction de sa température ;
  - à l'intérieur de chaque capsule (150 ; 250 ; 350 ; 550 ; 650 ; 750 ; 850) scellée sous vide, au moins une planche bolométrique (110; 210), adaptée à convertir en chaleur un rayonnement électromagnétique incident provenant de la capsule ;
  - au moins un filtre optique (160; 460; 560; 660; 760), pour arrêter un rayonnement électromagnétique dans l'infra-rouge, chaque capsule étant recouverte par un filtre optique ; et
  - des moyens de lecture (140 ; 840) des résistances électriques des planches bolométriques (110 ; 210).

**2.** Capteur (100 ; 300 ; 400 ; 500 ; 600 ; 700) selon la revendication 1, **caractérisé en ce qu'**il comprend une pluralité de capsules (150; 350; 550; 650; 750; 850), et **en ce qu'**une unique planche bolométrique est disposée à l'intérieur de chaque capsule.

**3.** Capteur (100; 200; 300; 400; 500; 600; 700) selon la revendication 1 ou 2, **caractérisé en ce que** chaque filtre optique (160 ; 460 ; 560 ; 660 ; 760) est en métal.

4. Capteur (100; 200; 300; 400; 500 ; 600 ; 700) selon la revendication 3, **caractérisé en ce que** l'impédance de chaque filtre optique (160 ; 460 ; 560 ; 660 ; 760) est au moins 50 fois inférieure à celle d'un vide à l'intérieur de chaque capsule.

5. Capteur (400) selon la revendication 3 ou 4, **caractérisé en ce que** chaque filtre optique (460) est connecté électriquement à une source de potentiel constant (462).

6. Capteur (100; 200; 300; 400; 500; 600; 700) selon l'une quelconque des revendications 1 à 5, **caractérisé en ce que** chaque capsule (150 ; 250 ; 350 ; 550 ; 650 ; 750 ; 850) présente une forme de capot dont une paroi supérieure est traversée par au moins un orifice (151 ; 551), et dont les parois latérales et supérieure coopèrent avec une couche inférieure, et une couche supérieure, pour englober un volume fermé (152).

7. Capteur (100; 200; 400; 500; 600; 700) selon l'une quelconque des revendications 1 à 6, **caractérisé en ce que** les capsules sont constituées de silicium amorphe ou d'un alliage comprenant du silicium amorphe.

8. Capteur (300) selon l'une quelconque des revendications 1 à 7, **caractérisé en ce que** les capsules comprennent :

   - une couche externe (350C) en silicium amorphe ou un alliage comprenant du silicium amorphe ; et
   - une couche interne (350D), présentant une émissivité dans l'infra-rouge supérieure à celle de la couche externe.

9. Capteur (500 ; 700) selon l'une quelconque des revendications 1 à 8, **caractérisé en ce que** les capsules (550 ; 750) sont séparées les unes des autres, sans contact physique direct entre elles.

10. Capteur (100 ; 300 ; 500 ; 700) selon l'une quelconque des revendications 1 à 9, **caractérisé en ce que** les filtres optiques (160 ; 560 ; 760) de différentes capsules (150 ; 350 ; 550 ; 750), ou lignes de capsules (750), sont séparés les uns des autres, sans contact physique direct entre eux.

11. Capteur (200 ; 400 ; 600 ; 700) selon l'une quelconque des revendications 1 à 10, **caractérisé en ce qu'**un filtre optique (260 ; 460 ; 660 ; 760) s'étendant d'un seul tenant au-dessus de plusieurs capsules présente des ouvertures traversantes situées entre les capsules.

12. Capteur (600 ; 700) selon l'une quelconque des revendications 3 à 11, **caractérisé en ce que** chaque filtre optique (660 ; 760) est connecté à une source de courant ou de tension de polarisation (680 ; 780 ; 880), pour l'injection d'un courant ou d'une tension adapté(e) à chauffer ledit filtre optique.

13. Capteur selon la revendication 12, **caractérisé en ce qu'**il comprend des moyens de pilotage (804), agencés pour actionner ladite source de courant ou de tension (880) pendant un intervalle de temps prédéterminé, et **en ce que** les moyens de lecture (840) sont connectés à des moyens de comparaison (805), pour déterminer une variation de la résistance électrique de la planche bolométrique, entre deux instants prédéterminés.

14. Procédé d'utilisation d'un capteur (700) selon la revendication 12 ou 13, **caractérisé en ce que** les planches bolométriques sont réparties en lignes pour former une matrice de planches bolométriques, et **en ce que** les filtres optiques (760) forment des lignes chauffantes, chacune au-dessus d'une ligne de planches bolométriques, une lecture des résistances électriques des planches bolométriques étant réalisée ligne par ligne, et un chauffage des filtres optiques étant également réalisé ligne par ligne et de façon synchrone avec la lecture des résistances électriques.

FIG.1

FIG.2

FIG.3

FIG.4

FIG.5

FIG.6

FIG.7A

FIG.7B

FIG.8A

FIG.8B

Europäisches
Patentamt

European
Patent Office

Office européen
des brevets

# RAPPORT DE RECHERCHE EUROPEENNE

Numéro de la demande

EP 17 15 8288

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| Y | EP 2 466 283 A1 (COMMISSARIAT ENERGIE ATOMIQUE [FR]) 20 juin 2012 (2012-06-20) * alinéas [0018], [0019], [0030], [0032], [0033], [0036]; figure 14.15.18.19 * ----- | 1-3,5-7 | INV. G06K9/00 G01J5/08 |
| Y | LOIC LE NOC ET AL: "Fingerprint recording with bolometric detectors", OPTICAL SENSING II, vol. 5071, 23 septembre 2003 (2003-09-23), page 442, XP055314693, 1000 20th St. Bellingham WA 98225-6705 USA ISSN: 0277-786X, DOI: 10.1117/12.487886 ISBN: 978-1-62841-971-9 * page 443, alinéa 2.1 - page 444, ligne 2.2 * ----- | 1-3,5-7 | |

**DOMAINES TECHNIQUES RECHERCHES (IPC)**

G01J
G06K

Le présent rapport a été établi pour toutes les revendications

| Lieu de la recherche | Date d'achèvement de la recherche | Examinateur |
|---|---|---|
| La Haye | 9 mars 2017 | Chateau, Jean-Pierre |

CATEGORIE DES DOCUMENTS CITES

X : particulièrement pertinent à lui seul
Y : particulièrement pertinent en combinaison avec un
    autre document de la même catégorie
A : arrière-plan technologique
O : divulgation non-écrite
P : document intercalaire

T : théorie ou principe à la base de l'invention
E : document de brevet antérieur, mais publié à la
    date de dépôt ou après cette date
D : cité dans la demande
L : cité pour d'autres raisons
.................................................................
& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 17 15 8288

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

09-03-2017

| Document brevet cité au rapport de recherche | Date de publication | Membre(s) de la famille de brevet(s) | Date de publication |
|---|---|---|---|
| EP 2466283 A1 | 20-06-2012 | CN 102538982 A | 04-07-2012 |
| | | EP 2466283 A1 | 20-06-2012 |
| | | FR 2969284 A1 | 22-06-2012 |
| | | JP 5926542 B2 | 25-05-2016 |
| | | JP 2012132898 A | 12-07-2012 |
| | | US 2012153151 A1 | 21-06-2012 |

EPO FORM P0460

Pour tout renseignement concernant cette annexe : voir Journal Officiel de l'Office européen des brevets, No.12/82

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 6633656 B
- EP 2466283 A

- EP 2743659 A

**Littérature non-brevet citée dans la description**

- Thermal Analysis of Fingerprint Sensor Having a Microheater Array. **JI-SONG HAN.** International Symposium on Micromechatronics and Human Science. IEEE, 1999